# EUROPEAN PATENT APPLICATION

(11) **EP 3 480 853 A1**
(43) Date of publication of application: **08.05.2019**
(21) Application number: 18203173.2
(22) Date of filing: 29.10.2018
(51) Int. Cl.: H01L 29/66, H01L 29/417, H01L 29/45, H01L 29/786

(54) **METHOD FOR MANUFACTURING THIN-FILM TRANSISTOR AND THIN-FILM TRANSISTOR**

(30) Priority: 01.11.2017 JP 2017212112
(71) Applicant: Sharp Kabushiki Kaisha, Sakai-shi Osaka 590-8522 (JP)
(72) Inventor: ITO, Kazuatsu, Osaka, 590-8522 (JP); NISHIKI, Hirohiko, Osaka, 590-8522 (JP)
(74) Representative: Müller-Boré & Partner Patentanwälte PartG mbB

(57) **Abstract**

A method for manufacturing a thin-film transistor that includes a source electrode and a drain electrode at least one of which has a layered structure of a plurality of metal layers including an Al layer and at least one layer made of a metal other than Al and a channel layer made of an oxide semiconductor includes forming a conductive film for the source electrode and the drain electrode, patterning the conductive film to form the source electrode and the drain electrode, forming a passivation film, and conducting heat treatment. The method includes preliminary heat treatment prior to the heat treatment, the preliminary heat treatment being conducted between the patterning of the conductive film and the formation of the passivation film.

## Description

### BACKGROUND

### 1. Field

The present disclosure relates to a method for manufacturing a thin-film transistor and to a thin-film transistor.

### 2. Description of the Related Art

In recent years, a display device including an active matrix substrate has been widely used. The active matrix substrate includes switching elements such as thin-film transistors (hereinafter, may be referred to as "TFTs") provided for corresponding pixels. An active matrix substrate including TFTs as switching elements is referred to as a "TFT substrate".

A TFT substrate used for a liquid crystal display device or the like includes, for example, a glass substrate, a plurality of TFTs supported on the glass substrate, a gate line, a source line, and pixel electrodes arranged in a matrix. A gate electrode, a source electrode, and a drain electrode of each of the TFTs are electrically connected to the gate line, the source line, and a pixel electrode, respectively. The TFTs, the source line, and the gate line are usually covered with an interlayer insulating layer. The pixel electrodes are provided on the interlayer insulating layer and connected to the drain electrodes of the TFTs in contact holes formed in the interlayer insulating layer.

Hitherto, TFTs including an amorphous silicon film as an active layer (hereinafter, may be referred to as "amorphous silicon TFTs") and TFTs including a polycrystalline silicon film as an active layer (hereinafter, may be referred to as "polycrystalline silicon TFTs") have been widely used as the TFTs. Recently, an oxide semiconductor has attracted attention as the material of the active layer of TFTs. Oxide semiconductor TFTs can operate at a higher speed than the amorphous silicon TFTs. An oxide semiconductor film is formed by a simpler process than that for forming the polycrystalline silicon film and therefore can be applied to devices required to have a large area. Herein, TFTs including an oxide semiconductor film as an active layer may be referred to as "oxide semiconductor TFTs".

In general, a source electrode of a TFT is formed from a conductive film that is the same as that used for a source line. A drain electrode and a gate electrode of the TFT are also similarly formed. Aluminum (Al) and Al alloys, which have high conductivity, are widely used as the materials of the conductive films. Recently, the use of copper (Cu), which has higher conductivity, has also been proposed. Herein, a layer formed from a conductive film that is the same as that including a source line may be referred to as a "source line layer".

The formation of the source line layer using the above metal such as Al enables the formation of a source line having a low wiring line resistance. On the other hand, when an Al film (or an Al alloy film) and a semiconductor layer of a TFT are brought into contact with each other, Al may diffuse into the inside of the semiconductor layer, and desired TFT characteristics may not be obtained. Similarly, when the source line layer is formed by using Cu, Cu may diffuse into the inside of the semiconductor layer, and desired TFT characteristics may not be obtained.
Furthermore, in a process of manufacturing a TFT substrate, when heat treatment (for example, at about 200°C to 600°C) is performed after the formation of a source line layer, the surface of an Al layer may be deformed, resulting in the generation of projections called hillocks. The hillocks on the surface of the Al layer decrease insulating properties of an interlayer insulating layer.

In view of the above circumstances, it has been proposed to form, for example, a source line layer using a layered film. For example, Japanese Unexamined Patent Application Publication Nos. 11-258625 and 2002-111004 disclose source and drain electrodes having a structure in which a molybdenum (Mo) layer, an Al layer, and a Mo layer are sequentially stacked. Japanese Unexamined Patent Application Publication No. 2010-123923 discloses that a titanium (Ti) layer is formed between an Al layer or a Cu layer and an oxide semiconductor layer. Japanese Unexamined Patent Application Publication No. 2010-123748 discloses source and drain electrodes having a structure in which a Ti layer, and Al layer, and a Ti layer are sequentially stacked.

As described above, a metal line of a TFT is generally formed to have a layered structure including Ti layers, Mo layers, or the like and an Al layer sandwiched therebetween in consideration of, for example, adhesion and reactivity to upper and lower layers of the metal line and productivity.

After an upper insulating film (hereinafter, also referred to as a "passivation film", "Pas film", or "protective film") is formed, an oxide semiconductor TFT is subjected to heat treatment (annealing) at 300°C or higher (for example, at 350°C for one hour). This is because it is necessary to reduce oxygen defects in an oxide semiconductor by diffusing oxygen from the Pas film.

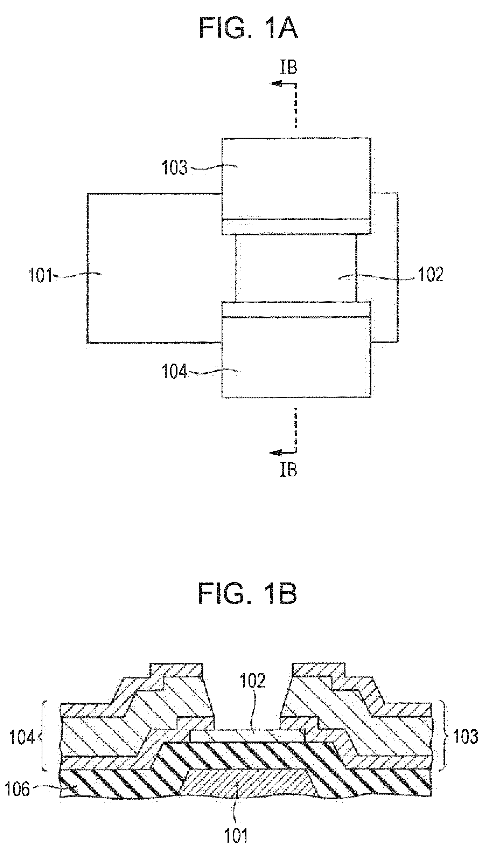

However, the heat treatment may degrade the covering ability of the passivation film. Hereinafter, the problem will be described with reference to Figs. 1A to 2B.

Figs. 1A and 1B are schematic views of main components of a bottom-gate thin-film transistor. Fig. 1A is a plan view, and Fig. 1B is a sectional view taken along line IB-IB in Fig. 1A.

Referring to Figs. 1A and 1B, the bottom-gate thin-film transistor includes a gate electrode 101, an oxide semiconductor layer (hereinafter, also referred to as a "channel layer") 102, and source/drain electrodes (hereinafter, also referred to as "S/D electrodes") 103 and 104 having a three-layer structure including Ti layers, Mo layers, or the like and an Al layer sandwiched therebetween. As illustrated in Fig. 1B, the bottom-gate thin-film transistor further includes a gate insulating film 106. The gate electrode 101 is connected to a gate line and thus hereinafter may be referred to as a "gate electrode line". The S/D electrodes 103 and 104 are connected to a wiring line and thus hereinafter may be referred to as an "S/D electrode line".

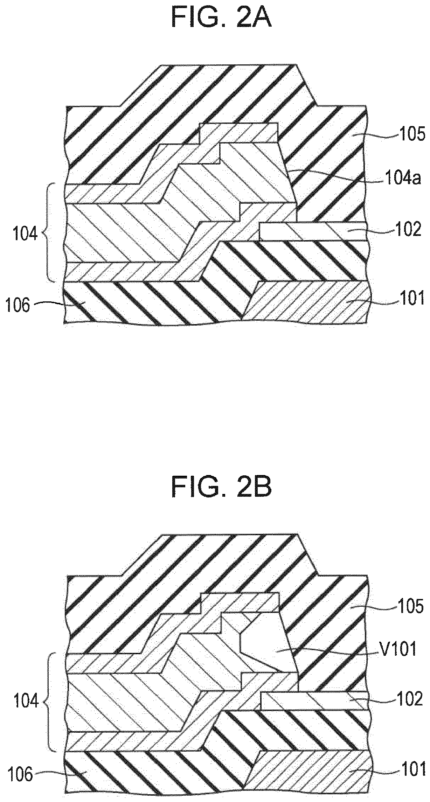

Fig. 2A is a sectional view illustrating an enlarged relevant part of a bottom-gate thin-film transistor before heat treatment. Fig. 2A illustrates that a passivation film 105 covers components including a channel layer 102 and an S/D electrode 104. However, the volume of an Al layer is changed (contracted or shrunk) by heat treatment. In addition, the amount of change in the volume of the Al layer is larger than that of Ti layers or Mo layers. Consequently, a void (gap) V101 is generated between the S/D electrode 104 and the passivation film 105, for example, in an end face 104a of the S/D electrode 104 (Fig. 2B).

Water in the air may reach the channel layer through the void formed as described above. The entry of water from the air to the channel layer may cause characteristic defects, resulting in a serious defect of degradation of TFT characteristics. In other words, the passivation film whose covering ability is degraded by heat treatment does not prevent water from entering, which may result in rapid degradation of a thin-film transistor (hereinafter, also referred to as "TFT degradation").

A description will be made by comparison between a bottom-gate thin-film transistor and a top-gate thin-film transistor.

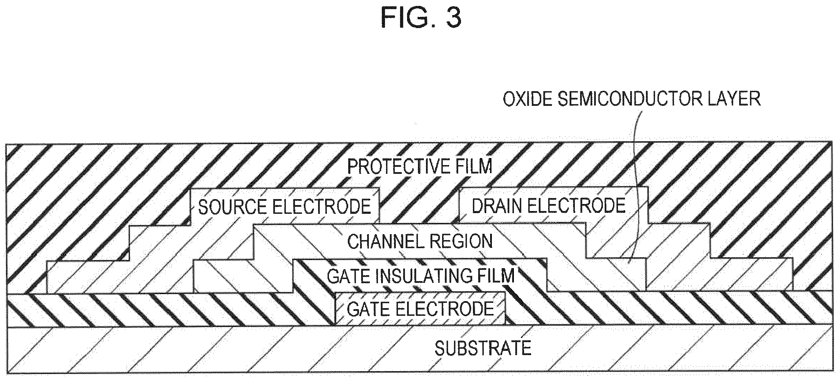

In a bottom-gate thin-film transistor, an S/D electrode line is disposed at a position farther from a substrate than a gate electrode line. When the bottom-gate thin-film transistor is illustrated such that a direction from a channel region toward the substrate is represented as a downward direction, the gate electrode line is disposed at a position lower than the S/D electrode line (Fig. 3).

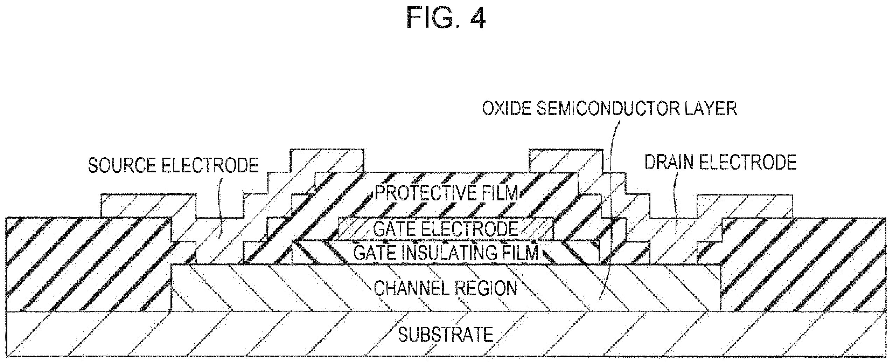

In contrast, in a top-gate thin-film transistor, an S/D electrode line is disposed at a position closer to a substrate than a gate electrode line. When the top-gate thin-film transistor is illustrated such that a direction from a channel region toward the substrate is represented as a downward direction, the gate electrode line is disposed at a position higher than the S/D electrode line (Fig. 4).

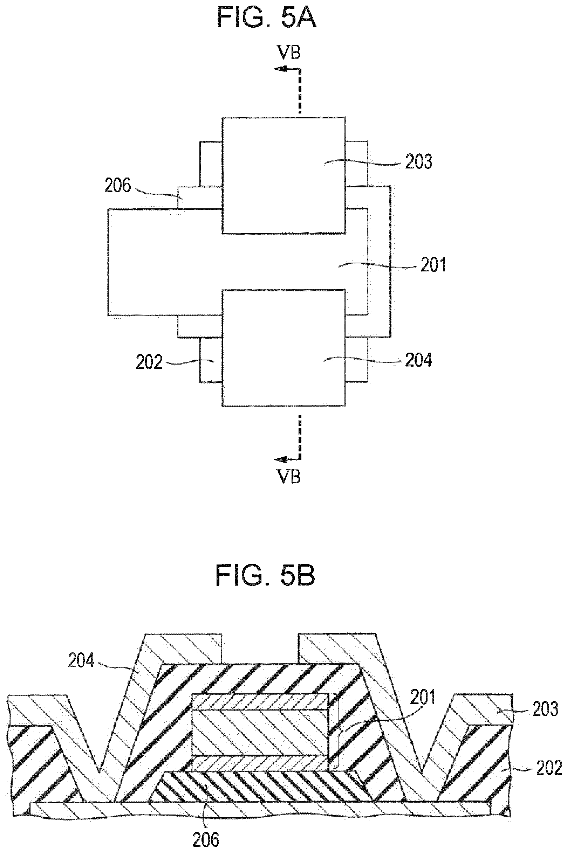

Figs. 5A and 5B are schematic views of main components of a top-gate thin-film transistor. Fig. 5A is a plan view, and Fig. 5B is a sectional view taken along line VB-VB in Fig. 5A.

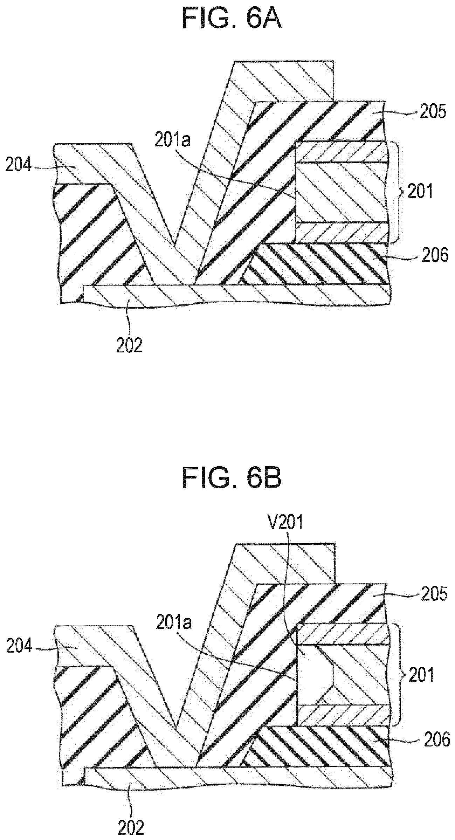

Referring to Figs. 5A and 5B, the top-gate thin-film transistor includes a gate electrode 201 having a three-layer structure including Ti layers, Mo layers, or the like and an Al layer sandwiched therebetween, a channel layer 202, S/D electrodes 203 and 204, and a gate insulating film 206. Fig. 6A is a sectional view illustrating an enlarged relevant part of a top-gate thin-film transistor before heat treatment. Fig. 6A illustrates that a passivation film 205 covers components including a channel layer 202 and a gate electrode 201.

As in the bottom-gate thin-film transistor described above, a volume change (contraction or shrinkage) of an Al layer occurs during annealing. Consequently, a void (gap, sign: V201) is generated between the gate electrode 201 and the passivation film 205, for example, in an end face 201a of the gate electrode 201 (Fig. 6B). Water may reach the channel layer through the void formed by heat treatment, resulting in rapid TFT degradation.

As described above, in the top-gate thin-film transistor, the covering ability of the passivation film may be degraded by heat treatment as in the bottom-gate thin-film transistor.

### SUMMARY

It is desirable to provide a method for manufacturing a thin-film transistor, the method being capable of suppressing degradation of the covering ability of a passivation film due to heat treatment, and the thin-film transistor.

According to an aspect of the disclosure, there is provided a method for manufacturing a thin-film transistor that includes a source electrode and a drain electrode at least one of which has a layered structure of a plurality of metal layers including an Al layer and at least one layer made of a metal other than Al and a channel layer made of an oxide semiconductor, the method including forming a conductive film for the source electrode and the drain electrode, patterning the conductive film to form the source electrode and the drain electrode, forming a passivation film, and conducting heat treatment. The method includes preliminary heat treatment prior to the heat treatment, the preliminary heat treatment being conducted between the patterning of the conductive film and the formation of the passivation film.

According to another aspect of the disclosure, there is provided a method for manufacturing a top-gate thin-film transistor that includes a gate electrode having a layered structure of a plurality of metal layers including an Al layer and at least one layer made of a metal other than Al and a channel layer made of an oxide semiconductor, the method including forming a conductive film for the gate electrode, patterning the conductive film to form the gate electrode, forming a passivation film, and conducting heat treatment. The method includes preliminary heat treatment prior to the heat treatment, the preliminary heat treatment being conducted between the patterning of the conductive film and the formation of the passivation film.

According to another aspect of the disclosure, there is provided a thin-film transistor including a channel layer, a source electrode, a drain electrode, a gate electrode, and a passivation film. In the thin-film transistor, the channel layer is made of an oxide semiconductor, at least one of the source electrode and the drain electrode has a layered structure of a plurality of metal layers including an Al layer and at least one layer made of a metal other than Al, and the passivation film is disposed so as to extend into a void formed, in the Al layer, in at least one of end faces of the source electrode and the drain electrode, the end faces facing each other.

According to another aspect of the disclosure, there is provided a thin-film transistor including a channel layer, a source electrode, a drain electrode, a gate electrode, and a passivation film. In the thin-film transistor, the channel layer is made of an oxide semiconductor, the gate electrode has a layered structure of a plurality of metal layers including an Al layer and at least one layer made of a metal other than Al, and the passivation film is disposed so as to extend into a void formed in the Al layer of a side face of the gate electrode.

### BRIEF DESCRIPTION OF THE DRAWINGS

Fig. 1A is a schematic plan view of main components of a bottom-gate thin-film transistor;
Fig. 1B is a sectional view taken along line IB-IB in Fig. 1A;
Fig. 2A is an enlarged view of a relevant part of an S/D electrode line and a channel layer on the left side of Fig. 1B and illustrates a state before annealing;
Fig. 2B is an enlarged view of a relevant part of an S/D electrode line and a channel layer on the left side of Fig. 1B and illustrates a state after annealing;
Fig. 3 is a schematic sectional view illustrating a typical structure of a bottom-gate thin-film transistor;
Fig. 4 is a schematic sectional view illustrating a typical structure of a top-gate thin-film transistor;
Fig. 5A is a schematic plan view of main components of a top-gate thin-film transistor;
Fig. 5B is a sectional view taken along line VB-VB in Fig. 5A;
Fig. 6A is an enlarged view of a relevant part of a gate electrode line and a channel layer on the left side of Fig. 5B and illustrates a state before annealing;
Fig. 6B is an enlarged view of a relevant part of a gate electrode line and a channel layer on the left side of Fig. 5B and illustrates a state after annealing;
Figs. 7A to 7G illustrate a method for manufacturing a bottom-gate thin-film transistor according to an embodiment of the present disclosure and process sectional views illustrating a method for manufacturing a bottom-gate thin-film transistor; and
Figs. 8A to 8G illustrate a method for manufacturing a top-gate thin-film transistor according to an embodiment of the present disclosure and process sectional views illustrating a method for manufacturing a top-gate thin-film transistor.

### DESCRIPTION OF THE EMBODIMENTS

The present disclosure will be described with reference to the attached drawings.

In the drawings used in the following description, in order to facilitate the understanding of features of the disclosure, feature points may be enlarged for convenience, and, for example, the dimensional ratio of each component may be different from that of actual ratio. For example, the materials and the dimensions exemplified in the description below are merely examples. The present disclosure is not limited thereto and can be carried out by changing as appropriate within the range in which advantageous effects of the disclosure are exhibited. Method for Manufacturing Bottom-Gate Thin-Film Transistor

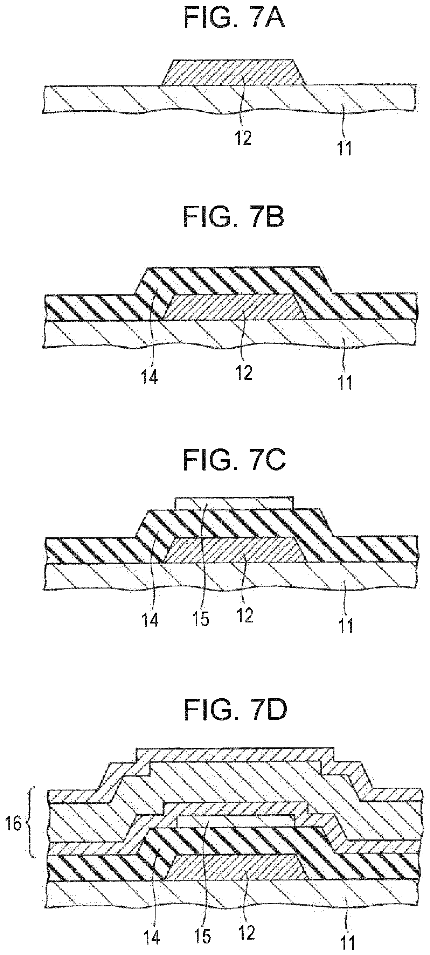

A method for manufacturing a bottom-gate thin-film transistor according to an embodiment of the present disclosure will be described with reference to Figs. 7A to 7G. Figs. 7A to 7G are process sectional views illustrating a method for manufacturing a bottom-gate thin-film transistor 10. In the following description, a direction from a substrate 11 toward a channel layer 15 is defined as an upward direction.

### Preparation of Substrate

First, a substrate 11 is prepared. For example, a glass substrate, a silicon substrate, or a plastic or resin substrate having heat resistance can be used as the substrate 11. Examples of the plastic substrate and the resin substrate include substrates made of polyethylene terephthalate (PET), polyethylene naphthalate (PEN), polyethersulfone (PES), an acrylic resin, or a polyimide.

For example, silicon oxide (SiOₓ), silicon nitride (SiNₓ), silicon oxynitride (SiOₓN_{y}) (x ≥ y), or silicon nitride oxide (SiNₓO_{y}) (x > y) may be optionally used as a base coating on the substrate.

### Formation of Gate Electrode

Next, as illustrated in Fig. 7A, a gate electrode 12 is formed on the substrate 11. The gate electrode 12 can be formed by depositing a conductive film on the substrate 11 by, for example, a sputtering method and subsequently patterning the conductive film by a photolithographic process. As the conductive film, a film made of a metal such as aluminum (Al), tungsten (W), molybdenum (Mo), tantalum (Ta), chromium (Cr), titanium (Ti), or copper (Cu), an alloy thereof, or a metal nitride thereof can be appropriately used. The conductive firm may be formed by stacking a plurality of layers made of any of these. For example, a conductive film including Ti layers and an Al layer sandwiched therebetween may be used as the conductive film. Adhesion between the Al layer and upper and lower layers of the conductive film can be improved by interposing the Ti layers or Mo layers therebetween. Alternatively, for example, the conductive film can be formed by depositing a tungsten (W) film and a tantalum nitride (TaN) film (W/TaN = 370 nm/50 nm) by using a sputtering apparatus and subsequently patterning the films by a photolithographic method and a dry etching method to form a desired pattern. Deposition of Gate Insulating Film

Next, as illustrated in Fig. 7B, a gate insulating film 14 is formed on the gate electrode 12. The gate insulating film 14 can be formed by, for example, a chemical vapor deposition (CVD) method. The gate insulating film may be a single-layer film or a multi-layer film. As the gate insulating film, a film made of, for example, silicon oxide (SiOₓ), silicon nitride (SiNₓ), silicon oxynitride (SiOₓN_{y}) (x ≥ y), or silicon nitride oxide (SiNₓO_{y}) (x > y) can be appropriately used. In order to prevent diffusion of, for example, impurities from the substrate, a gate insulating film on the lower layer side is preferably formed by using, for example, silicon nitride (SiNₓ) or silicon nitride oxide (SiNₓO_{y}) (x > y), and a gate insulating film on the upper layer side is preferably formed by using, for example, silicon oxide (SiOₓ) or silicon oxynitride (SiOₓN_{y}) (x ≥ y). In order to form, at a lower deposition temperature, a dense insulating film having a low gate leakage current, a rare-gas element such as argon may be contained in reaction gas so as to be mixed in the insulating film. For example, a SiN layer (325 nm) and a SiO₂ layer (50 nm) can be continuously deposited on the gate electrode 12 using a CVD apparatus.

### Formation of Channel Layer (Oxide Semiconductor Layer)

Next, as illustrated in Fig. 7C, a channel layer (oxide semiconductor layer) 15 is formed on the gate insulating film 14. The channel layer 15 can be formed by depositing a thin film for an oxide semiconductor layer on the gate insulating film 14 by, for example, a sputtering method or a CVD method and subsequently patterning the thin film for an oxide semiconductor layer by a photolithographic process. For example, a thin film for an oxide semiconductor layer is deposited on the gate insulating film 14 by a sputtering method so as to have a thickness of 30 to 100 nm and subsequently etched by a photolithographic process using a resist mask to form a desired pattern.

The oxide semiconductor contained in the channel layer 15 may be an amorphous oxide semiconductor or a crystalline oxide semiconductor having a crystalline portion. Examples of the crystalline oxide semiconductor include polycrystalline oxide semiconductors, microcrystalline oxide semiconductors, and crystalline oxide semiconductors having a c-axis that is oriented approximately perpendicular to a layer surface thereof.

The channel layer may have a layered structure including two or more layers. When the channel layer 15 has a layered structure, the channel layer 15 may include an amorphous oxide semiconductor layer and a crystalline oxide semiconductor layer. Alternatively, the channel layer 15 may include a plurality of crystalline oxide semiconductor layers having different crystal structures. Alternatively, the channel layer 15 may include a plurality of amorphous oxide semiconductor layers. When the channel layer 15 has a two-layer structure including an upper layer and a lower layer, the energy gap of an oxide semiconductor contained in the upper layer is preferably larger than the energy gap of an oxide semiconductor contained in the lower layer. However, when the difference in energy gap between these layers is relatively small, the energy gap of the oxide semiconductor contained in the lower layer may be larger than the energy gap of the oxide semiconductor contained in the upper layer.

The materials, structures, and deposition methods of the above amorphous oxide semiconductors and crystalline oxide semiconductors and configurations of the oxide semiconductor layers having layered structures are described in, for example, Japanese Unexamined Patent Application Publication No. 2014-007399. For the purpose of reference, the entire disclosures of Japanese Unexamined Patent Application Publication No. 2014-007399 are incorporated herein by reference.

The channel layer 15 may contain at least one metal element selected from In, Ga, and Zn. The channel layer 15 contains, for example, an In-Ga-Zn-O-based semiconductor (hereinafter, may be abbreviated as "IGZO"). The In-Ga-Zn-O-based semiconductor is a ternary oxide of In (indium), Ga (gallium), and Zn (zinc), and the ratio (compositional ratio) of In, Ga, and Zn is not particularly limited. The ratio of In, Ga, and Zn may be, for example, In:Ga:Zn = 2:2:1, In:Ga:Zn = 1:1:1, or In:Ga:Zn = 1:1:2. The channel layer 15 may include an In-Ga-Zn-O-based semiconductor layer containing In, Ga, and Zn in a ratio of In:Ga:Zn = 1:1:1.

TFTs including an In-Ga-Zn-O-based semiconductor layer have high mobility (more than 20 times that of a-Si TFT) and low leakage current (less than 1/100 of that of a-Si TFT) and therefore are suitably used as driving TFTs and pixel TFTs. The use of TFTs including an In-Ga-Zn-O-based semiconductor layer enables the power consumption of display devices to be considerably reduced.

The In-Ga-Zn-O-based semiconductor may be amorphous or may have a crystalline portion. The crystalline In-Ga-Zn-O-based semiconductor may be a crystalline In-Ga-Zn-O-based semiconductor having a c-axis that is oriented approximately perpendicular to a layer surface thereof. The crystal structure of such an In-Ga-Zn-O-based semiconductor is disclosed in, for example, Japanese Unexamined Patent Application Publication No. 2012-134475.

The channel layer 15 may contain another oxide semiconductor instead of the In-Ga-Zn-O-based semiconductor. The channel layer 15 may contain, for example, an In-Sn-Zn-O-based semiconductor (for example, In₂O₃-SnO₂-ZnO), an In-Al-Zn-O-based semiconductor, a Zn-O-based semiconductor (ZnO), an In-Zn-O-based semiconductor (IZO (registered trademark)), a Zn-Ti-O-based semiconductor (ZTO), a Cd-Ge-O-based semiconductor, a Cd-Pb-O-based semiconductor, InGaO₃(ZnO)₅, magnesium zinc oxide (MgₓZn₁₋ₓO), cadmium zinc oxide (CdₓZn₁₋ₓO), cadmium oxide (CdO), a Mg-Zn-O-based semiconductor, or an In-Ga-Sn-O-based semiconductor. The Zn-O-based semiconductor used may be ZnO to which at least one impurity element selected from, for example, group 1 elements, group 13 elements, group 14 elements, group 15 elements, and group 17 elements is added, the ZnO being in an amorphous (non-crystalline) state, a polycrystalline state, or a microcrystalline state in which an amorphous state and a polycrystalline state are mixed, or ZnO to which no impurity element is added.

Formation of Conductive Film for Electrodes (Conductive Film Deposition Step)

Next, as illustrated in Fig. 7D, a conductive film 16 for forming a source electrode and a drain electrode is formed over the entire surface of the channel layer 15 and the gate insulating film 14. The conductive film 16 has a three-layer structure including layers made of a metal other than Al and an Al layer sandwiched therebetween. For example, a metal such as titanium (Ti) or molybdenum (Mo), an alloy thereof, or a metal nitride thereof can be appropriately used as the material of at least one of the layers disposed on and under the aluminum (Al) layer, the layers being made of a metal other than Al. With this configuration, adhesion between the channel layer 15, the conductive film 16, and a passivation film 17 can be improved. For example, a Ti layer (50 nm) is formed on the gate insulating film 14 and the channel layer 15, and an Al layer (300 nm) and a Ti layer (30 nm) are sequentially stacked on the Ti layer by sputtering deposition. Thus, a conductive film 16 including the Ti layers and the Al layer sandwiched therebetween can be formed. Good conductivity can be obtained because the conductive film 16 includes the Al layer. In addition, good adhesion between the conductive film 16 and the gate insulating film 14, the channel layer 15, and a passivation film 17 can be achieved because the Ti layers are disposed between these layers.

### Formation of Source Electrode and Drain Electrode

### (Patterning Step)

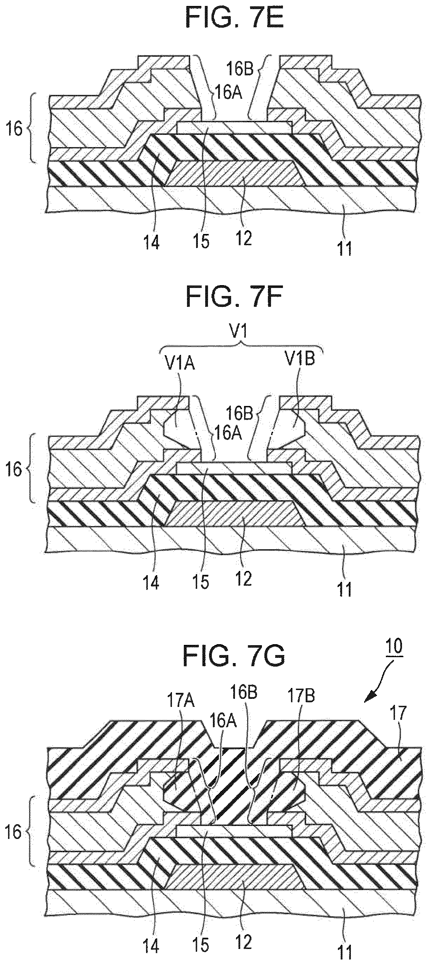

Next, as illustrated in Fig. 7E, the conductive film 16 for electrodes is processed by a photolithographic process using a resist mask so as to have a desired shape. Thus, a source electrode 16A or a drain electrode 16B is formed.

### Preliminary Heat Treatment Step

Next, heat is applied to the Al layer in the source electrode 16A or the drain electrode 16B. As illustrated in Fig. 7F, the volume of the Al layer changes (contracts or shrinks), and a cavity (void, sign: V1) is formed in the end face of the source electrode 16A or the drain electrode 16B. In Fig. 7F, a void formed in the end face of the source electrode 16A is denoted by V1A, and a void formed in the end face of the drain electrode 16B is denoted by V1B. By performing this heat treatment prior to a heat treatment step described later, the amount of shrinkage of the Al layer in the heat treatment step can be reduced. Accordingly, the generation of voids in the heat treatment step can be suppressed. Therefore, even after the heat treatment step, the passivation film can be in close contact with the channel layer, the Al layer, and the layers made of a metal other than Al. This configuration inhibits water from reaching the channel layer to a practically sufficient degree.

The temperature in the preliminary heat treatment step may be higher than the temperature in the heat treatment step. Adoption of such a temperature condition further inhibits water from reaching the channel layer.

For example, when the conductive film 16 has a layered structure of Ti layer/Al layer/Ti layer, this substrate may be heated to 300°C to 400°C (for example, 350°C). In this case, shrinking of the Al layer easily occurs without diffusion of hydrogen contained in the Al layer and the Ti layers into the channel layer 15. Thus, the process time can be reduced. Note that when the temperature of this substrate is increased to 450°C or higher, hydrogen contained in the Al layer and the Ti layers diffuses into the channel layer 15, which may result in poor characteristics (characteristic defects).

Furthermore, the heating is preferably performed for one hour or more. The Al layer can be sufficiently shrunk. On the other hand, the heating time is preferably short in view of productivity. Accordingly, the preliminary heat treatment may be performed in which a time determined from the viewpoint of productivity is defined as an upper limit. The upper limit may be 2 hours.

The heating method is not particularly limited, and a known method can be used. For example, a heating furnace or laser heating can be suitably used. The method used may be a method in which only the Al layer is selectively heated, or a method in which not only the Al layer but also a part, such as the substrate, other than the Al layer is heated.

The gate electrode 12 may be shrunk in the preliminary heat treatment step and/or the heat treatment step as well as the source electrode 16A or the drain electrode 16B but is not particularly limited thereto. Formation of Passivation Film (Pas Film or Protective Film)

### (Passivation Film Formation Step)

Next, as illustrated in Fig. 7G, a passivation film (Pas film) 17 which is an insulating film is formed so as to cover the whole of the structure formed as described above. The passivation film 17 can be formed so as to extend into the voids of the Al layer, the voids being formed in the preliminary heat treatment step. Alternatively, the passivation film 17 can be formed such that the voids are filled with the passivation film 17. In Fig. 7G, the insides of the void V1A and the void V1B are respectively filled with end portions 17A and 17B of the passivation film 17 so as not to form gaps or pores. However, the present disclosure is not limited to the embodiment illustrated in Fig. 7G as long as sufficient covering ability of the passivation film is obtained in terms of practical use.

The passivation film 17 is formed so as to have a thickness of, for example, about 300 to 500 nm. The passivation film 17 can be formed by a method for forming a thin film, such as a plasma CVD method or a sputtering method, using an insulating material such as silicon nitride, silicon oxide, silicon nitride oxide, or silicon oxynitride.

Subsequently, a resist mask is formed on the passivation film (Pas film) 17 by a photolithographic process, and etching for a contact hole is performed. The passivation film (Pas film) 17 is not limited to a single layer. The passivation film (Pas film) 17 may include two layers or three or more layers. A film that comes in contact with the channel layer 15 (for example, an IGZO layer) preferably contains oxygen. A planarizing film formed of an organic insulating material may be further formed on the passivation film (Pas film) 17.

### Heat Treatment Step (Annealing)

Subsequently, the passivation film (Pas film) 17 is subjected to heat treatment. Oxygen can be diffused from the passivation film (Pas film) 17 to reduce oxygen defects in the oxide semiconductor. A heat treatment step (annealing) is performed at a temperature of about 200°C to 400°C for about 0.5 to 2 hours. The heat treatment step can be performed, for example, at 300°C for one hour. The heating method is not particularly limited, and a known method can be used. For example, a heating furnace or a laser can be used.

### Formation of Common Electrode

Subsequently, a transparent conductive film such as an ITO film or an IZO film is deposited by, for example, a sputtering method over the entire surface of the substrate 11 having the passivation film (Pas film) 17 thereon. The transparent conductive film is then subjected to photolithography, wet etching, resist removal, and washing to form a transparent electrode.

The bottom-gate thin-film transistor according to an embodiment of the present disclosure can be suitably manufactured by the method described above.

In the above embodiment, the conductive film 16 has a three-layer structure including layers made of a metal other than Al and an Al layer sandwiched therebetween. Alternatively, the conductive film 16 may have a two-layer structure including an Al layer and a layer made of a metal other than Al.

Subsequently, steps similar to those of a typical method for manufacturing a liquid crystal display device are performed to obtain a display device in which a liquid crystal layer is held by being disposed between substrates facing each other.

### Bottom-Gate Thin-Film Transistor

In the bottom-gate thin-film transistor manufactured by the method described above, the passivation film is formed so as to extend into the voids formed, in the Al layer, in the end faces of the source electrode and the drain electrode, the end faces facing each other. Furthermore, the passivation film can be in close contact with the channel layer, the Al layer, and the layers made of a metal other than Al, the Al layer and the layers serving as the source electrode and the drain electrode. This configuration inhibits water from reaching the channel layer to a practically sufficient degree.

### Method for Manufacturing Top-Gate Thin-Film Transistor

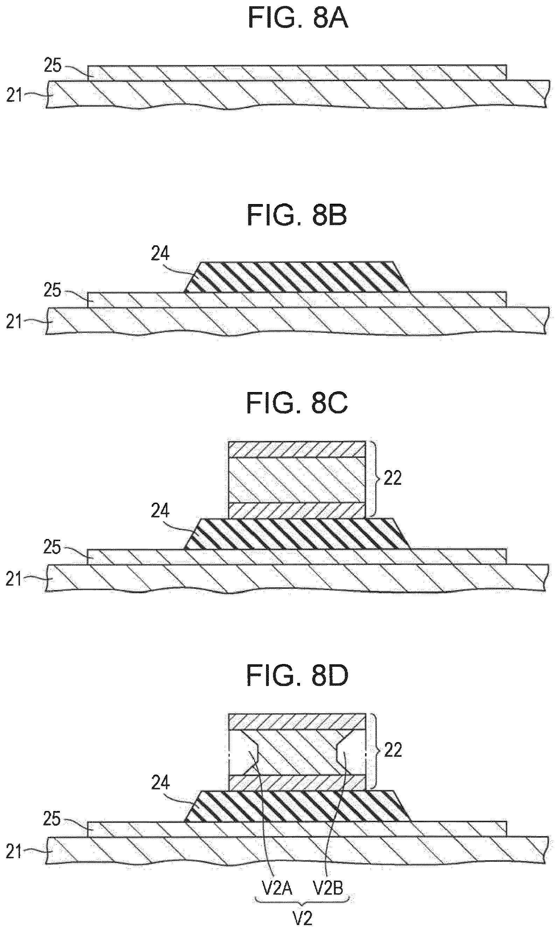

Next, a method for manufacturing a top-gate thin-film transistor according to an embodiment of the present disclosure will be described with reference to Figs. 8A to 8G. Figs. 8A to 8G are process sectional views illustrating a method for manufacturing a top-gate thin-film transistor 20. In the following description, a direction from a substrate 21 toward a channel layer 25 is defined as an upward direction.

### Preparation of Substrate

First, a substrate 21 is prepared. For example, a glass substrate, a silicon substrate, or a plastic or resin substrate having heat resistance can be used as the substrate 21. Examples of the plastic substrate and the resin substrate include substrates made of polyethylene terephthalate (PET), polyethylene naphthalate (PEN), polyethersulfone (PES), an acrylic resin, or a polyimide.

For example, silicon oxide (SiOₓ), silicon nitride (SiNₓ), silicon oxynitride (SiOₓN_{y}) (x ≥ y), or silicon nitride oxide (SiNₓO_{y}) (x > y) may be optionally used as a base coating on the substrate.

### Formation of Channel Layer (Oxide Semiconductor Layer)

Next, as illustrated in Fig. 8A, a channel layer 25 is formed on the substrate 21. The channel layer 25 can be formed by depositing a thin film for an oxide semiconductor layer on the substrate 21 by, for example, a sputtering method or a CVD method and subsequently patterning the thin film for an oxide semiconductor layer by a photolithographic process. For example, a film of an oxide semiconductor is deposited on the substrate 21 by a sputtering method so as to have a thickness of 30 to 100 nm and subsequently etched by a photolithographic process using a resist mask to form a desired pattern. The oxide semiconductor used may be an oxide semiconductor having the same crystallinity, layered structure, composition, and the like as those of the oxide semiconductor used in the above a bottom-gate thin-film transistor according to an embodiment of the present disclosure.

### Deposition of Gate Insulating Film

Next, as illustrated in Fig. 8B, a gate insulating film 24 is formed on the channel layer 25. The gate insulating film 24 can be formed by, for example, a CVD method. The gate insulating film may be a single-layer film or a multi-layer film. As the gate insulating film, a film made of, for example, silicon oxide (SiOₓ), silicon nitride (SiNₓ), silicon oxynitride (SiOₓN_{y}) (x ≥ y), or silicon nitride oxide (SiNₓO_{y}) (x > y) can be appropriately used. In order to prevent diffusion of, for example, impurities from the substrate, a gate insulating film on the lower layer side is preferably formed by using, for example, silicon nitride (SiNₓ)or silicon nitride oxide (SiNₓO_{y}) (x > y), and a gate insulating film on the upper layer side is preferably formed by using, for example, silicon oxide (SiOₓ)or silicon oxynitride (SiOₓN_{y}) (x ≥ y). In order to form, at a lower deposition temperature, a dense insulating film having a low gate leakage current, a rare-gas element such as argon may be contained in reaction gas so as to be mixed in the insulating film. For example, a SiN layer (325 nm) and a SiO₂ layer (50 nm) can be continuously deposited on the channel layer 25 using a CVD apparatus.

### Formation of Conductive Film for Electrode (Conductive Film Deposition Step)

Next, a conductive film for forming a gate electrode is formed on the gate insulating film 24. The conductive film has a three-layer structure including layers made of a metal other than Al and an Al layer sandwiched therebetween as in the conductive film for forming a source electrode and a drain electrode in the above method for manufacturing a bottom-gate thin-film transistor according to an embodiment of the present disclosure. For example, a metal such as titanium (Ti) or molybdenum (Mo), an alloy thereof, or a metal nitride thereof can be appropriately used as the material of at least one of the layers disposed on and under the aluminum (Al) layer, the layers being made of a metal other than Al. With this configuration, adhesion between the conductive film, the gate insulating film 24, and a passivation film 27 can be improved. For example, the conductive film can be formed by depositing a Ti layer (50 nm) on the gate insulating film 24 and the channel layer 25, and sequentially stacking an Al layer (300 nm) and a Ti layer (30 nm) on the Ti layer by sputtering. Good conductivity can be obtained because the conductive film includes the Al layer. In addition, good adhesion between the conductive film, the gate insulating film 24, and the passivation film 27 can be achieved because the Ti layers are disposed between these layers.

### Formation of Gate Electrode (Patterning Step)

Next, as illustrated in Fig. 8C, the conductive film for an electrode is processed by a photolithographic process using a resist mask so as to have a desired shape. Thus, a gate electrode 22 is formed.

### Preliminary Heat Treatment Step

Next, heat is applied to the Al layer in the gate electrode 22. As in the above method for manufacturing a bottom-gate thin-film transistor according to an embodiment of the present disclosure, the volume of the Al layer changes (contracts or shrinks), and cavities (voids, signs: V2A and V2B) are formed in the end faces of the conductive film, as illustrated in Fig. 8D. By performing this heat treatment prior to a heat treatment step described later, the amount of shrinkage of the Al layer in the heat treatment step can be reduced. Accordingly, the generation of voids in the heat treatment step can be suppressed. Therefore, even after the heat treatment step, the passivation film 27 can be in close contact with the channel layer 25, and the Al layer and the layers made of a metal other than Al in the gate electrode 22. This configuration inhibits water from reaching the channel layer to a practically sufficient degree.

The temperature in the preliminary heat treatment step may be higher than the temperature in the heat treatment step described later. Adoption of such a temperature condition further inhibits water from reaching the channel layer.

For example, when the conductive film for the gate electrode has a layered structure of Ti layer/Al layer/Ti layer, this substrate may be heated to 300°C to 400°C (for example, 350°C). In this case, shrinking of the Al layer easily occurs, and the process time can be reduced. Note that when the temperature of this substrate is increased to 450°C or higher by heating, hydrogen generated from the gate insulating film diffuses into the channel layer, which may result in degradation of reliability of the TFT element.

Furthermore, the heating is preferably performed for one hour or more. The Al layer can be sufficiently shrunk. On the other hand, the heating time is preferably short in view of productivity. Accordingly, the preliminary heat treatment may be performed in which a time determined from the viewpoint of productivity is defined as an upper limit. The upper limit may be 2 hours.

The heating method is not particularly limited, and a known method can be used. For example, a heating furnace or laser heating can be suitably used. The method used may be a method in which only the Al layer is selectively heated, or a method in which not only the Al layer but also a part, such as the substrate, other than the Al layer is heated.

### Formation of Passivation Film (Pas Film or Protective Film) (Passivation Film Formation Step)

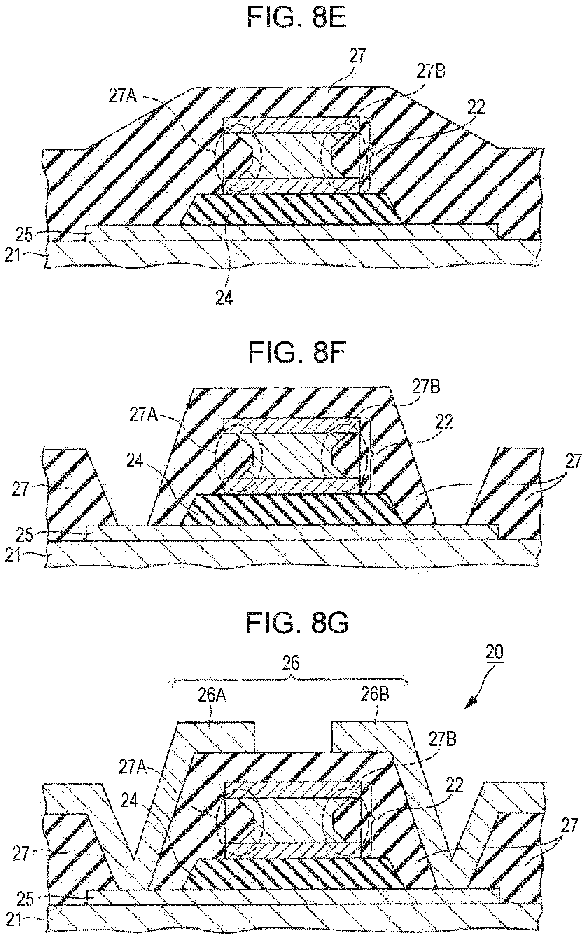

Next, a passivation film (Pas film) 27 which is an insulating film is formed so as to cover the whole of the structure formed as described above (Fig. 8E). The passivation film 27 can be formed such that end portions 27A and 27B of the passivation film 27 extend into the voids V2 (V2A and V2B) of the Al layer, the voids V2 being formed in the preliminary heat treatment step. Alternatively, the passivation film 27 can be formed such that the voids V2 (V2A and V2B) are filled with the end portions 27A and 27B of the passivation film 27. In Fig. 8E, the insides of the voids V2A and V2B are respectively filled with the end portions 27A and 27B of the passivation film 27 so as not to form gaps or pores. However, the present disclosure is not limited to the embodiment illustrated in Fig. 8E as long as sufficient covering ability of the passivation film is obtained in terms of practical use.

The passivation film 27 can be formed so as to have a thickness of, for example, about 300 to 500 nm. This insulating film can be formed by a method for forming a thin film, such as a plasma CVD method or a sputtering method, using an insulating material such as silicon nitride, silicon oxide, silicon nitride oxide, or silicon oxynitride.

Subsequently, as illustrated in Fig. 8F, a resist mask is formed on the passivation film 27 by a photolithographic process, and etching for contact holes is performed. The passivation film (Pas film) 27 is not limited to a single layer. The passivation film (Pas film) 27 may include two layers or three or more layers. A film that comes in contact with the channel layer 25 (for example, an IGZO layer) preferably contains oxygen. A planarizing film formed of an organic insulating material may be further formed on the passivation film (Pas film) 27.

### Formation of Source Electrode and Drain Electrode

### (Conductive Film Deposition Step)

Next, a conductive film 26 for forming a source electrode 26A and a drain electrode 26B is formed over the entire surface of the passivation film 27. As illustrated in Fig. 8G, the source electrode 26A and the drain electrode 26B are formed. The source electrode 26A and the drain electrode 26B can be formed by depositing the conductive film 26 on the substrate 21 by, for example, a sputtering method and subsequently patterning the conductive film 26 by a photolithographic process. As the conductive film 26, a film made of a metal such as aluminum (Al), tungsten (W), molybdenum (Mo), tantalum (Ta), chromium (Cr), titanium (Ti), or copper (Cu), an alloy thereof, or a metal nitride thereof can be appropriately used. The conductive firm 26 may be formed by stacking a plurality of layers made of any of these. For example, a conductive film including Ti layers and an Al layer sandwiched therebetween may be used as the conductive film 26. Adhesion between the Al layer and upper and lower layers of the conductive film 26 can be improved by interposing the Ti layers or Mo layers therebetween. Alternatively, for example, the conductive film 26 can be formed by depositing a tungsten (W) film and a tantalum nitride (TaN) film (W/TaN = 370 nm/50 nm) by using a sputtering apparatus and subsequently patterning the films by a photolithographic method and a dry etching method to form a desired pattern.

The source electrode 26A and the drain electrode 26B may be shrunk in the preliminary heat treatment step and/or the heat treatment step as well as the gate electrode 22 but are not particularly limited thereto.

### Heat Treatment Step (Annealing)

Subsequently, the passivation film 27 is subjected to heat treatment. Oxygen can be diffused from the passivation film 27 to reduce oxygen defects in the oxide semiconductor (for example, IGZO) in the channel layer 25. A heat treatment step (annealing) is performed at a temperature of about 200°C to 400°C for about 0.5 to 2 hours. The heat treatment step can be performed, for example, at 300°C for one hour.

The heating method is not particularly limited, and a known method can be used. For example, a heating furnace or a laser can be used. The method used may be a method in which only the passivation film 27 is selectively heated, or a method in which not only the passivation film 27 but also a part, such as the substrate, other than the passivation film 27 is heated.

### Formation of Common Electrode

Subsequently, a transparent conductive film such as an ITO film or an IZO film is deposited by, for example, a sputtering method over the entire surface of the substrate 21 having the passivation film 27, the source electrode 26A, and the drain electrode 26B thereon. The transparent conductive film is then subjected to photolithography, wet etching, resist removal, and washing to form a transparent electrode.

The top-gate thin-film transistor according to an embodiment of the present disclosure can be suitably manufactured by the method described above.

In the above embodiment, the gate electrode 22 has a three-layer structure including layers made of a metal other than Al and an Al layer sandwiched therebetween. Alternatively, the gate electrode 22 may have a two-layer structure including an Al layer and a layer made of a metal other than Al.

Subsequently, steps similar to those of a typical method for manufacturing a liquid crystal display device are performed to obtain a display device in which a liquid crystal layer is held by being disposed between substrates facing each other.

### Top-Gate Thin-Film Transistor

In the top-gate thin-film transistor manufactured by the method described above, the passivation film is formed so as to extend into the voids formed in the Al layer of the end faces of the gate electrode. Furthermore, the passivation film can be in close contact with the channel layer, the Al layer, and the layers made of a metal other than Al, the Al layer and the layers serving as the gate electrode. This configuration inhibits water from reaching the channel layer to a practically sufficient degree.

The present disclosure contains subject matter related to that disclosed in Japanese Priority Patent Application JP 2017-212112 filed in the Japan Patent Office on November 1, 2017, the entire contents of which are hereby incorporated by reference.

It should be understood by those skilled in the art that various modifications, combinations, subcombinations and alterations may occur depending on design requirements and other factors insofar as they are within the scope of the appended claims or the equivalents thereof.

## Claims

1. A method for manufacturing a thin-film transistor that includes a source electrode and a drain electrode at least one of which has a layered structure of a plurality of metal layers including an Al layer and at least one layer made of a metal other than Al and a channel layer made of an oxide semiconductor, the method comprising:
forming a conductive film for the source electrode and the drain electrode;
patterning the conductive film to form the source electrode and the drain electrode;
forming a passivation film; and
conducting heat treatment,
wherein the method includes preliminary heat treatment prior to the heat treatment, the preliminary heat treatment being conducted between the patterning of the conductive film and the formation of the passivation film.

2. The method for manufacturing a thin-film transistor according to Claim 1, wherein the preliminary heat treatment is conducted at a temperature equal to or higher than a temperature of the heat treatment.

3. The method for manufacturing a thin-film transistor according to Claim 1, wherein the conductive film has a two-layer structure including a first layer made of a metal other than Al and the Al layer or a three-layer structure including a first layer made of a metal other than Al, the Al layer, and a second layer made of a metal other than Al.

4. A thin-film transistor comprising:
a channel layer;
a source electrode;
a drain electrode;
a gate electrode; and
a passivation film,
wherein the channel layer is made of an oxide semiconductor,
at least one of the source electrode and the drain electrode has a layered structure of a plurality of metal layers including an Al layer and at least one layer made of a metal other than Al, and
the passivation film is disposed so as to extend into a void formed, in the Al layer, in at least one of end faces of the source electrode and the drain electrode, the end faces facing each other.
